# EUROPEAN PATENT APPLICATION

(11) **EP 0 641 077 A2**
(43) Date of publication of application: **01.03.1995**
(21) Application number: 94305760.4
(22) Date of filing: 03.08.1994
(51) Int. Cl.: H03K 3/013

(54) **Fixed logic level circuit with ESD protection**

(30) Priority: 26.08.1993 US 112830
(71) Applicant: Hewlett-Packard Company, Palo Alto, California 94304 (US)
(72) Inventor: Reed, Mark John, Albany, OR 97321 (US); McDougal, Jay Dean, Corvallis, OR 97330 (US); Kasper, Kristine Marie, Corvallis, OR 97330 (US)
(74) Representative: Colgan, Stephen James

(57) **Abstract**

A fixed logic level circuit with electrostatic discharge (ESD) protection is disclosed. The circuit contains two transistors, neither of which have their gates connected to the voltage source or ground lines. A logical high signal ("1") is outputted from the source of one transistor, while a logical low signal ("0") is outputted from the drain of the other transistor. The isolation of the logical high and low signals from the voltage source line and ground line protects this circuit and other circuitry using the logical high and low signals from voltage transients, such as ESD events. An additional transistor may be added to the circuit to prevent the circuit from entering an incorrect state.

## Description

### Field of the Invention

This invention relates to the electronics circuitry field. More particularly, this invention is a circuit which provides ESD protected high and low fixed logic levels to other circuitry in a reliable manner.

### Background of the Invention

Modern digital circuitry is capable of performing a nearly unlimited number of useful and complex functions in response to the receipt of just two input signals -- a logical "high" signal ("1") and a logical "low" signal ("0") -- at appropriate places and times within the circuitry. In the absence of these input signals, this same marvelous circuitry is just glorified sand. In less colorful terminology, digital circuitry depends on a reliable source of logical high and low signals for proper operation.

The flexibility and power of modern digital circuitry has meant that many mundane mechanical and electro-mechanical devices have been replaced with digital circuitry. For example, automobiles and airplanes are now almost entirely controlled by digital circuitry instead of by the tubes, relays, gears, levers, hydraulics and pneumatics of yesteryear. While this evolution has resulted in dramatically increased function at a dramatically lower cost and size, it has not been without its drawbacks. One such drawback is the susceptibility of digital circuitry to electrostatic discharge events, or ESD. ESD events can come from anything from static electricity to a lightning strike. Whether the ESD event comes from Kitty getting friendly with your computer or the gods deciding that aircraft really doesn't belong up in the sky during lightning storms, the results can be the catastrophic failure of the circuit.

### Summary of the Invention

It is a primary object of the invention to provide a circuit capable of supplying high and low fixed logic levels to other circuitry.

It is another object of the invention to provide a circuit capable of supplying ESD protected high and low fixed logic levels to other circuitry.

It is another object of the invention to provide a circuit capable of supplying ESD protected high and low fixed logic levels to other circuitry, where the circuit is prevented from entering an incorrect state.

These and other objects of the invention are accomplished by the fixed logic level circuit with ESD protection disclosed herein.

A fixed logic level circuit with electrostatic discharge (ESD) protection is disclosed. The circuit contains two transistors, neither of which have their gates connected to the voltage source or ground lines. A logical high signal ("1") is outputted from the source of one transistor, while a logical low signal ("0") is outputted from the drain of the other transistor. The isolation of the logical high and low signals from the voltage source line and ground line protects this circuit and other circuitry using the logical high and low signals from voltage transients, such as ESD events. An additional transistor may be added to prevent the circuit from entering an incorrect state.

### Description of the Drawings

Figs. 1A-1B show a crude prior art method of providing logical high and low signals to other circuitry.

Fig. 2A-2B show the traditional prior art method of providing logical high and low signals to other circuitry.

Fig. 3 shows the fixed logic level circuit with electrostatic discharge (ESD) protection of the invention.

Fig. 4A shows the circuit of Fig. 3 with added prevention from entering an incorrect state.

Fig. 4B shows one equivalent circuit to the circuit of the invention shown in Fig. 4A.

Fig. 5 shows the circuit of Fig. 4A with buffered outputs.

Fig. 6 shows a graph of the operation of the circuit of the invention.

### Detailed Description of the Preferred Embodiment

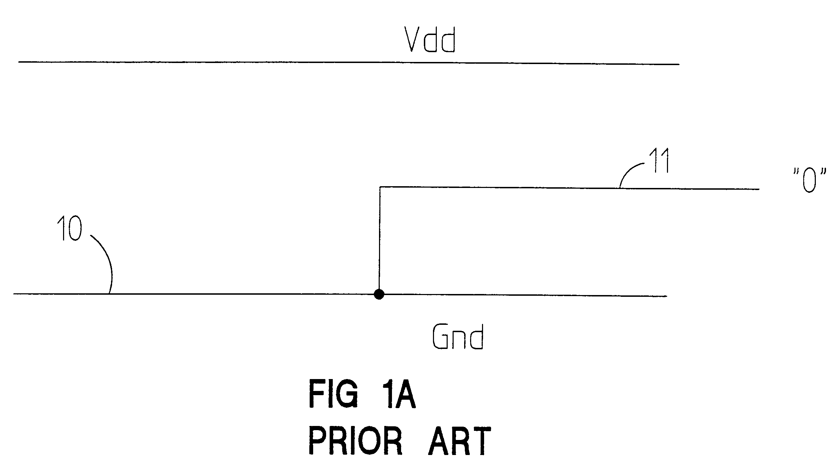

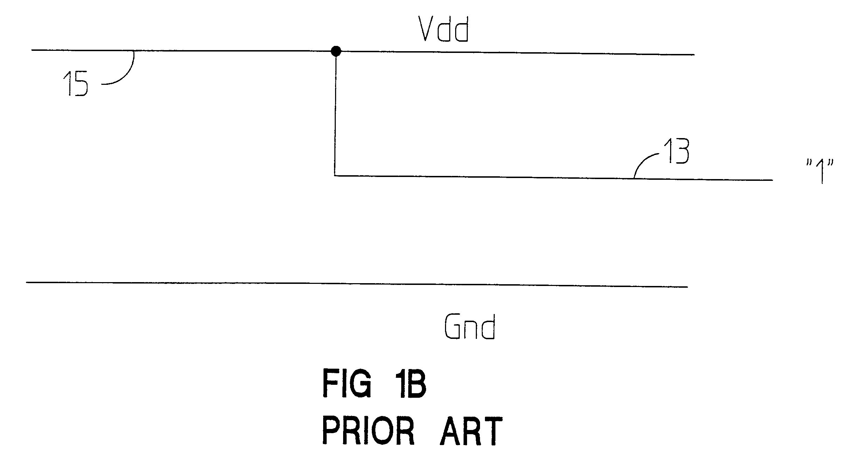

Figs. 1A-1B show a crude prior art method of providing logical high and low signals to other circuitry. Fig. 1A shows how logical low signal line 11 can be provided by merely tapping ground line 10. Likewise, Fig. 1B shows how logical high signal line 13 can be provided by merely tapping voltage source line 15. While adequate for some circuits, this approach offers no ESD protection. In addition, the actual values of the logical high and low signals can float undesirably with noise or other signals present on voltage source line 15 and ground line 10.

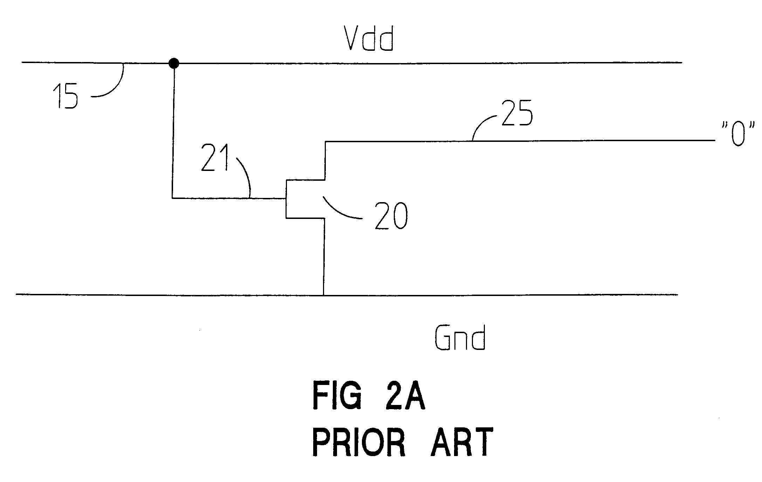

Fig. 2A-2B show another prior art method of providing logical high and low signals to other circuitry. Fig. 2A shows transistor 20, where gate 21 is connected to voltage source line 15. When voltage is present on voltage source line 15, transistor 20 turns on, thereby pulling logical low signal line 25 low. Note that transistor 20 is capable of being damaged by an ESD event occurring on voltage source line 15. If transistor 20 is damaged, it can no longer reliably provide a logical low signal to other circuitry.

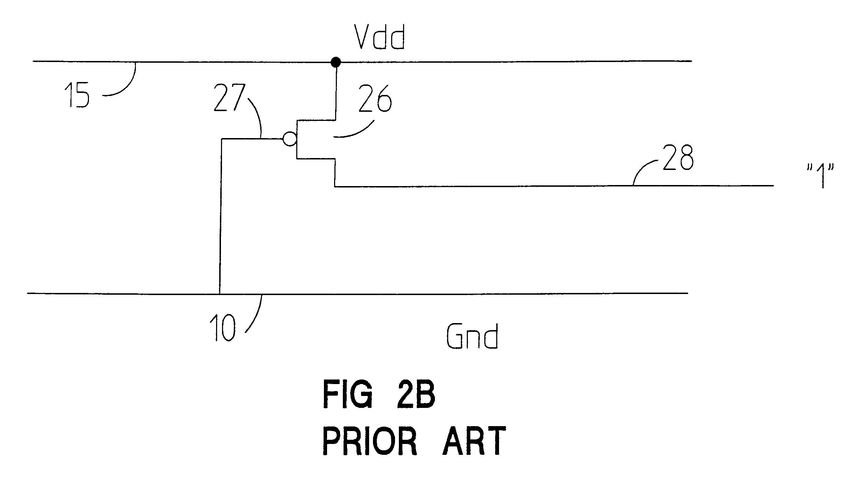

Fig. 2B shows transistor 26, where gate 27 is connected to ground line 10. When voltage is not present on ground line 10, transistor 26 turns on, thereby pulling logical high signal line 28 high. Note that transistor 26 is capable of being damaged by an ESD event occurring on ground line 10. If transistor 26 is damaged, it can no longer reliably provide a logical high signal to other circuitry.

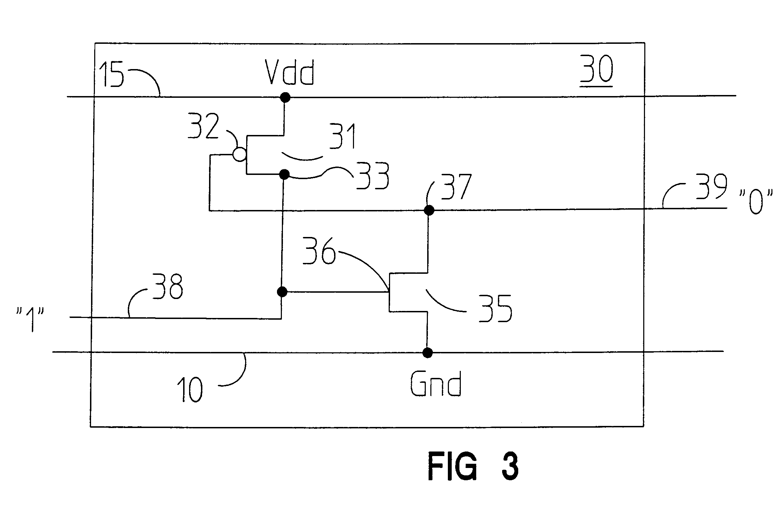

Fig. 3 shows fixed logic level circuit with electrostatic discharge (ESD) protection of the invention. For purposes of this invention, the term "ESD protection" shall mean a circuit that is not adversely affected by the occurrence of an unexpected change of voltage on either the voltage source line or the ground line, where this change of voltage results in a voltage level that exceeds the gate breakdown voltage of one or more transistors in the circuit. This unexpected change in voltage can result from any voltage transient, such as a lightning strike, static electricity, voltage surge from high powered components, etc.

Referring again to Fig. 3, note that gate 32 of transistor 31 and gate 36 of transistor 35 are not connected to either voltage source line 15 or ground line 10. This isolation protects circuit 30 and other circuitry dependent on circuit 30 for reliable logical high and low signals from ESD events.

As voltage is present on voltage source line 15, transistor 31 is on, and logical high signal line 38, connected to source 33 of transistor 31, is pulled to the voltage level on voltage source line 15. Stated another way, transistor 31 drives logical high signal line 38. This turns on transistor 35, and pulls logical low line 39, connected to drain 37 of transistor 35, to the voltage level on ground line 10. Transistor 35, therefore, drives logical low signal line 39.

While transistors used in circuit 30 are MOSFETs in the preferred embodiment, those skilled in the art will appreciate that other components, such as bipolar or JFET transistors, etc, could also be used. In the preferred embodiment, circuit 30 is part of a standard cell library available to circuit designers in the fabrication of application specific integrated circuits, although it could also be constructed out of discrete devices or custom designed on a chip.

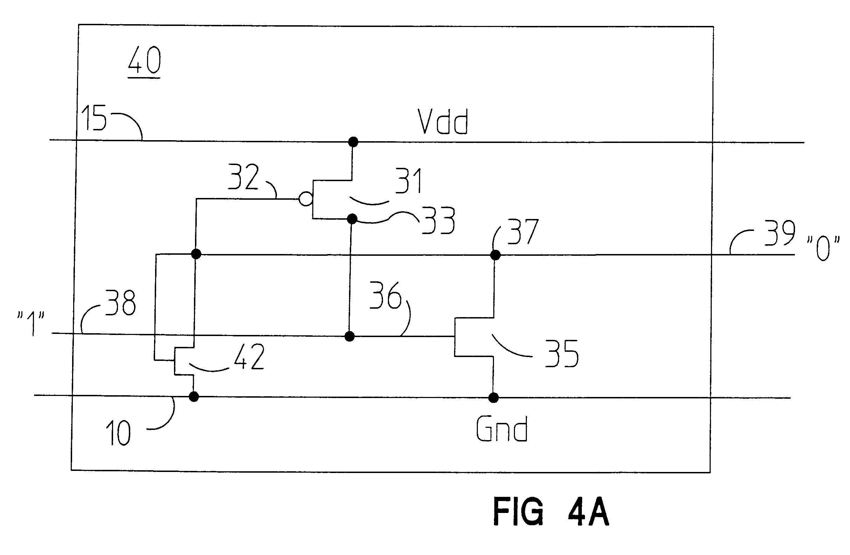

Fig. 4A shows the circuit of Fig. 3 with added prevention from entering an incorrect state. For the purposes of this invention, an "incorrect state" is a condition where anything other than a logical "0", such as a logical "1", exists on the logical low signal line, and/or where anything other than a logical "1", such as a logical "0", exists on the logical high signal line, when the circuit is powered up or during operation. While in theory the circuit of Fig. 3 should never be in an incorrect state, this cannot be guaranteed to always be the case in the real world, where prudent designers take external factors and the practical and physical limitations and variations of electronic circuitry into account.

Referring again to Fig. 4A, circuit 40 contains all of the circuitry of circuit 30 (Fig. 3). In addition, circuit 40 contains transistor 42. Transistor 42 assures that circuit 40 always remains in a state where logical low signal line 39 outputs a logical "0" and logical high signal line 38 outputs a logical "1" (i.e. a correct state). The instant a high voltage is detected at logical low line 39 (i.e. the circuit is about to enter an incorrect state), transistor 42 turns on and partially discharges logical low signal line 39. This turns on transistor 31, which charges logical high signal line 38. This turns on transistor 35, which fully discharges logical low signal line 39. When the voltage levels on logical low signal line 39 and logical high signal line 38 are normal, transistor 42 turns off and circuit 40 operates the same as circuit 30 (Fig. 3). In this manner, circuit 40 is prevented from entering an incorrect state.

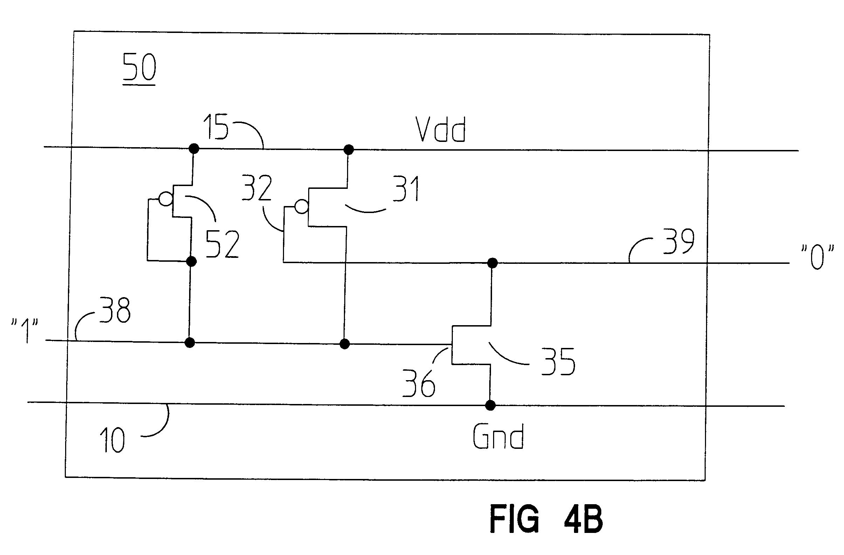

Fig. 4B shows circuit 50, which is a functional equivalent to the circuit 40 shown in Fig. 4A. Transistor 42 of Fig. 4A has been replaced by transistor 52, a p-junction FET in the preferred embodiment. The instant a low voltage is detected at logical high signal line 38, transistor 52 turns on and partially charges logical high signal line 38. This turns on transistor 35, which discharges logical low signal line 39. This turns on transistor 31, which fully charges logical high signal line 38. When the voltage levels on logical low signal line 39 and logical high signal line 38 are normal, transistor 52 turns off and circuit 50 operates the same as circuit 30 (Fig. 3).

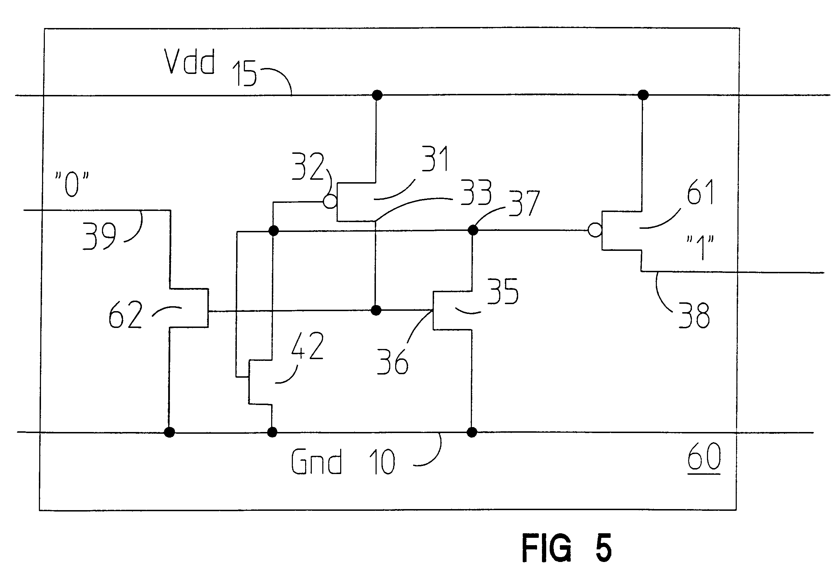

Fig. 5 shows circuit 40 of Fig. 4A with buffered outputs. In addition to the components contained in circuit 40, circuit 60 of Fig. 5 also contains transistors 61 and 62. These transistors buffer the output lines to prevent unwanted charge from entering the circuit. These transistors also allow the circuit to handle resistive loads and achieve a lower output impedance. Note that since transistors 61 and 62 act as inverters, logical low output line 39 is now driven by source 33 of transistor 31 (through transistor 62), and logical high output line 38 is now driven by drain 37 of transistor 35 (through transistor 61).

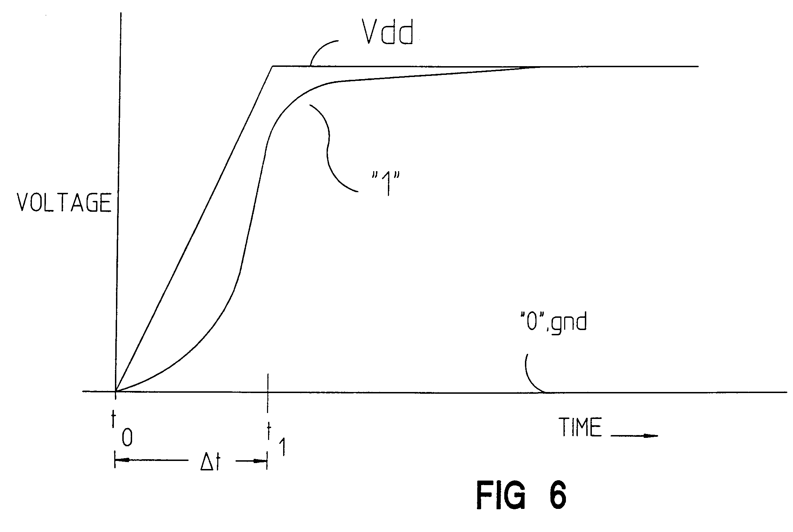

Fig. 6 shows a graph of the operation of circuit 30 of the invention. As voltage source line 15 goes high between short period of time Δt, the voltage on logical high signal line 38 quickly approaches the supply voltage Vdd. The voltage on logical low signal line 39 stays at the level of ground line 10.

While this invention has been described with respect to the preferred and alternate embodiments, it will be understood by those skilled in the art that various changes in detail may be made therein without departing from the spirit, scope and teaching of the invention. For example, the circuits shown in the drawings could be replaced by other equivalent circuit structures. Accordingly, the herein disclosed is to be limited only as specified in the following claims.

## Claims

1. An electronic circuit (40) having a voltage source line (15) and a ground line (10), comprising:
a first transistor (31) having a gate (32) unconnected to either said voltage source line or said ground line;
a second transistor (35) having a gate (36) unconnected to either said voltage source line or said ground line;
a first output line (39) for outputting a logical low signal, said first output line driven by said first transistor;
a second output line (38) for outputting a logical high signal, said second output line driven by said second transistor;
wherein said first output line is electronically isolated from said voltage source line and said ground line; and
wherein said second output line is electronically isolated from said voltage source line and said ground line.

2. The electronic circuit of claim 1, further comprising:
a third transistor (42) connected to said first transistor, said third transistor turning on if it detects that said circuit is about to enter an incorrect state, thereby preventing said circuit from entering an incorrect state.

3. The electronic circuit of claim 2, further comprising:
a fourth transistor (61) connected to said first transistor for buffering said first output line.

4. The electronic circuit of claim 3, further comprising:
a fifth transistor (62) connected to said second transistor for buffering said second output line.
